# EUROPEAN PATENT APPLICATION

(11) **EP 4 686 987 A1**
(43) Date of publication of application: **04.02.2026**
(21) Application number: 25192774.5
(22) Date of filing: 30.07.2025
(51) Int. Cl.: G05B 13/04, G05B 19/418, G06F 30/13, G06Q 50/06

(54) **INFORMATION PROCESSING APPARATUS, INFORMATION PROCESSING METHOD, AND PROGRAM**

(30) Priority: 02.08.2024 JP 2024128113
(71) Applicant: Yokogawa Electric Corporation, Tokyo 180-8750 (JP)
(72) Inventor: KONISHI, Takumi, Musashino-shi, Tokyo 180-8750 (JP)
(74) Representative: Winter, Brandl - Partnerschaft mbB

(57) **Abstract**

An information processing apparatus (1) includes an acquisition unit (51) that acquires pipeline information (22-1) related to pipes (p) that connect a plurality of modules (2) included in a modular plant and construction information (40) including information related to the modules, and a specifying unit (52) that specifies, based on the acquired construction information, pipe information (70) related to a selection and an arrangement of pipelines to be placed between the plurality of modules.

## Description

### BACKGROUND OF THE INVENTION

### 1. Field of the Invention

The present disclosure relates to an information processing apparatus, an information processing method, and a program.

### 2. Description of the Related Art

Modular Type Package (MTP) is a technology that supports a design and an operation of a modular plant. The MTP provides a digital file that defines a function, performance, and interface requirements of a specific process module. An apparatus for constructing production line, provided in the modular plant, integrates modules obtained from different manufacturers by using the MTP technology and designs a configuration of the entire plant such that the configuration is able to be easily modified. In conventional plant design, each part of the process is custom designed and built as an integrated system.

Patent Document 1: Japanese Laid-open Patent Publication No. 2010-152776

### SUMMARY OF THE INVENTION

However, in the conventional design of the modular plant, as a result of each of the parts of the process being custom designed and built as the integrated system, a design, construction, and expansion of the plant are time-consuming and costly.

Accordingly, the present disclosure has been conceived in light of the circumstances described above and an object thereof is to provide an information processing apparatus, an information processing method, and a program that is able to efficiently reduce the time and cost needed for a generation process performed in a plant including design, construction, expansion of the plant.

According to an aspect of an embodiment, an information processing apparatus includes a memory and a processor coupled to the memory and the processor configured to acquire pipeline information related to pipes that connect a plurality of modules included in a modular plant and construction information including information related to the modules and specify, based on the acquired construction information, pipe information related to a selection and an arrangement of pipelines to be placed between the plurality of modules.

According to other aspect of an embodiment, an information processing method includes acquiring pipeline information related to pipes that connect a plurality of modules included in a modular plant and construction information including information related to the modules and specifying, based on the acquired construction information, pipe information related to a selection and an arrangement of pipelines to be placed between the plurality of modules, by processing circuitry.

According to other aspect of an embodiment, a non-transitory computer-readable recording medium stores a program that causes a computer to execute a process includes acquiring pipeline information related to pipes that connect a plurality of modules included in a modular plant and construction information including information related to the modules and specifying, based on the acquired construction information, pipe information related to a selection and an arrangement of pipelines to be placed between the plurality of modules.

### BRIEF DESCRIPTION OF THE DRAWINGS

### DETAILED DESCRIPTION OF THE PREFERRED EMBODIMENTS

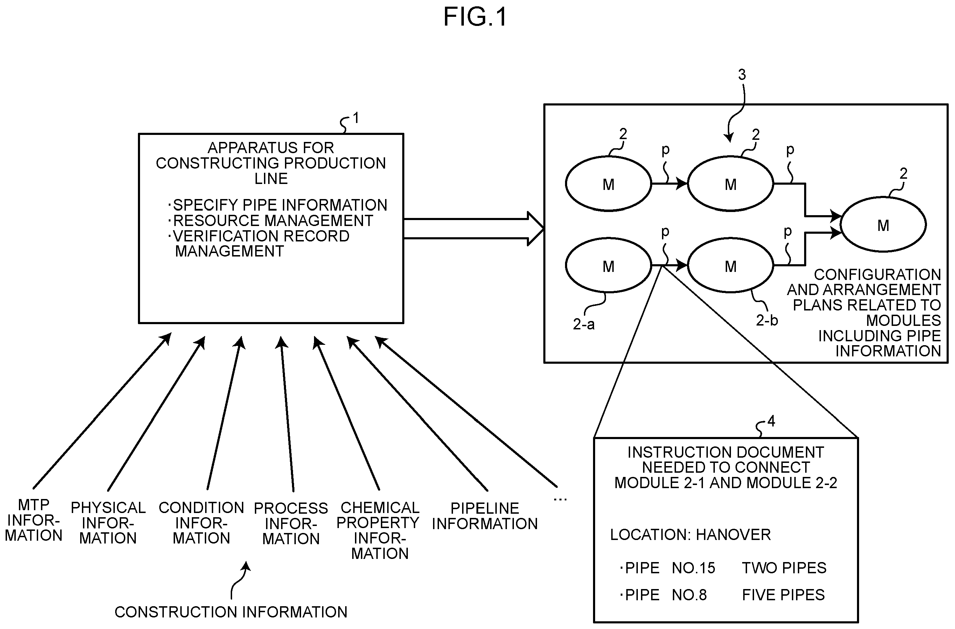

[0010] FIG. 1 is a diagram illustrating the outline of an operation of an apparatus according to an embodiment;
FIG. 2 is a diagram illustrating the outline of an operation of the apparatus according to the embodiment with respect to a configuration plan and an arrangement plan of an already-existing module;
FIG. 3 is a functional block diagram illustrating a configuration of an apparatus according to a first embodiment;
FIG. 4 is a diagram illustrating construction information stored in a plant design DB that is included in the apparatus according to the first embodiment;
FIG. 5 is a functional block diagram of an engine unit included in the apparatus according to the first embodiment;
FIG. 6 is a diagram illustrating a first example of a relationship between an output and an objective function and a constraint condition of the algorithm of the apparatus according to the first embodiment;
FIG. 7 is a diagram illustrating a second example of a relationship between an output and the objective function and the constraint conditions of the algorithm of the apparatus according to the first embodiment;
FIG. 8 is a diagram illustrating specified pipe information on the apparatus according to the first embodiment;
FIG. 9 is a diagram illustrating one example of a screen that is used to input constraint condition information and that is provided in the apparatus according to the first embodiment;
FIG. 10 is a diagram illustrating one example of a screen that is used to input objective function information and that is provided in the apparatus according to the first embodiment;
FIG. 11 is a diagram illustrating one example of a plan configuration and an arrangement plan of modules including pipe information in a case where energy consumption is minimized;
FIG. 12 is a diagram illustrating one example of a plan configuration and an arrangement plan of the module including the pipe information in a case where production efficiency is maximized;
FIG. 13 is a diagram illustrating an example of an instruction document of pipes that are needed to connect the modules;
FIG. 14 is a flowchart illustrating the flow of an operation of the apparatus according to the first embodiment;
FIG. 15 is a functional block diagram of an apparatus according to a second embodiment;
FIG. 16 is a functional block diagram of an engine unit included in the apparatus according to the second embodiment;
FIG. 17 is a diagram illustrating a first example of a resource allocation of a stock before change and a resource allocation of a stock after change in the apparatus according to the second embodiment;
FIG. 18 is a diagram illustrating a second example of the resource allocation of a stock before change and a resource allocation of a stock after change in the apparatus according to the second embodiment;
FIG. 19 is a flowchart illustrating the flow of an operation of the apparatus according to the second embodiment;
FIG. 20 is a functional block diagram of an apparatus according to a third embodiment;
FIG. 21 is a functional block diagram of the engine unit included in the apparatus according to the third embodiment;
FIG. 22 is a diagram illustrating the verification record DB included in the apparatus according to the third embodiment;
FIG. 23 is a flowchart illustrating an operation of the apparatus according to the third embodiment; and
FIG. 24 is a diagram illustrating an example of a hardware configuration of the apparatus according to the embodiment.

In the following, preferred embodiments of the present disclosure will be explained in detail below with reference to the accompanying drawings. In the present application and drawings, by assigning the same reference numerals to the same or equivalent components having substantially the same functional configuration, overlapping descriptions thereof will be appropriately omitted.

### (1. Outline)

### (1.1. Conventional problem)

In the conventional design of a modular plant, as described above, each of the parts of the process is custom designed and built as the integrated system, so that a design, construction, and expansion of the plant are time-consuming and costly.

Problems of the apparatus provided in a conventional modular plant will be specifically described.

In the conventional MTP technology, a process module is defined at a logical level, and the function of modules and requirements for process control are designated. These modules are selected at a design phase of the plant, and combined, and then, form the entire process flow. In the conventional technology, a physical arrangement of these modules and an interaction between the modules in the actual plant are secondary considerations, and the conventional technology have mainly focused on a logical cooperation and optimization of the process flow. The problems in the conventional technology will be specifically described below.

### 1. Complexity of physical connection of modules:

In the conventional MTP technology, a physical connection between the modules is made only based on simplified logical information, so that a physical join of the module performed in the actual plant generates a lot of issues in terms of a selection and an arrangement of pipelines. In particular, selecting appropriate pipes and correctly joining the pipes are the problems that need a lot of efforts and time.

### 2. Lack of information management on modules and pipelines:

In the conventional apparatus, information management on the pipelines each of which is connected to the modules is insufficient, and it is difficult for a worker to accurately and promptly join the modules. In the conventional apparatus, it is difficult for the worker to accurately and promptly join the modules, and thus, verification of the quality management and the process is complicated.

### 3. Absence of efficient resource management:

In the conventional apparatus, as an enormous increase in the number of MTP modules, it is further difficult to accurately grasp the type and the quantity of the pipes that are needed to be held and appropriately manage the pipes. The difficulty of accurately and promptly joining the modules becomes a major factor in reducing the efficiency and flexibility of the plant, and thus, the verification of the quality management and the process becomes complicated. In particular, a lack of efficient information management and a consistency check performed by utilizing Radio Frequency Identification (RFID) or a bar code is noticeable.

In other words, the main problem in the conventional MTP technology is summarized to the complexity of the physical connection between the modules, the lack of the information management, and the absence of the efficient resource management.

### (1.2. Explanation of apparatus for constructing production line according to the present disclosure)

The apparatus according to the present disclosure is provided to solve the problems of the complexity of the physical connection, the lack of the information management, and the absence of the efficient resource management that have been occurred in the conventional MTP technology, and efficiently reduce the time and cost needed for a generation process performed in a plant. Specifically, the apparatus according to the present disclosure improves optimization of the physical connection, strengthening of the information management, and efficiency of the resource management that will be described below.

### 1. Optimization of physical connection:

The apparatus according to the present disclosure integrates not only the logical information but also the process information and the physical information and optimizes the physical arrangement of each of the modules by using 3D CAD in order to solve the complexity of the physical connection occurred in the conventional technology. With the apparatus according to the present disclosure, as a result of optimizing the physical arrangement of each of the modules by using the 3D CAD, it is possible to smoothly join the modules in the actual plant and it is possible to perform designing of the pipelines with the shortest and optimum arrangement.

### 2. Strengthening of information management:

The apparatus according to the present disclosure utilizes the technology of the RFID, the bar code, or the like, manages the information on the modules and the pipelines each of which is connected to the modules in real time, and performs a consistency check. As a result of this, the apparatus according to the present disclosure supports the worker such that the worker is able to promptly and accurately join the modules, and make quality management and verification of the process more efficient.

### 3. Improvement of efficiency in resource management:

The apparatus according to the present disclosure grasps the type and the quantity of pipelines in real time in order to cope with an enormous number of modules, and appropriately manages the pipelines. The apparatus according to the present disclosure increases the efficiency and flexibility in the plant, and also contributes to a reduction in cost.

### (1.3. Outline of apparatus according to the present disclosure)

The apparatus according to the present disclosure proposes a new method to enable efficient management and operation of the modules with intelligent selection of pipes as its core. The apparatus according to the present disclosure uses complex data including a physical property and a chemical property of each of the modules, the management location (for example, Hanover or Beijing) of the modules, and the like.

Furthermore, the apparatus according to the present disclosure belongs to the field of technology that increases the flexibility and efficiency of a manufacturing process by combining a plurality of independent modules.

In addition, the apparatus according to the present disclosure particularly utilizes the MTP technology, and is able to modularizes the processes of the products performed between manufacturing and packaging the products and is able to easily recombine these modules. The apparatus according to the present disclosure promptly and efficiently changes and expands the manufacturing lines.

In addition, the production line that is constructed by the apparatus according to the present disclosure is applicable to manufacturing plants that are used in the fields of, in particular, chemistry, medical and pharmaceutical products, food processing, electronic component manufacturing, and the like. Furthermore, the modular plant provided by the apparatus according to the present disclosure considerably increases flexibility, expandability, and customizability of the processes performed in the field of, in particular, chemistry, medical and pharmaceutical products, food processing, electronic component manufacturing, and the like.

Furthermore, the apparatus according to the present disclosure is applicable to the entire manufacturing processes performed between raw material processing and final product packaging. Furthermore, the apparatus according to the present disclosure is flexible enough to be applicable to an auxiliary process, such as quality management or disposal of waste.

In addition, the apparatus according to the present disclosure is applicable to manufacturing various kinds of products including synthesis of chemical agents, manufacturing of medical and pharmaceutical products, processes of food products, assembly of electronic components, or the like. In addition, the apparatus according to the present disclosure is also applicable to an environment technology or a recycling process, and contributes to construction of a sustainable manufacturing process.

In addition, the apparatus according to the present disclosure is provided to ensure improvement of productivity and flexibility in manufacturing industry as an alternative to a fixed manufacturing line that has been conventionally used. Furthermore, the apparatus according to the present disclosure provides significant advantages, in particular, in the contemporary manufacturing industry in which a change in product in a short period of time or small lot production is required.

FIG. 1 is a diagram illustrating the outline of an operation of an apparatus 1 for constructing a production line according to the embodiment. In FIG. 1, the apparatus 1 specifies pipe information that is related to pipes p each of which connects modules 2 and that is indicated by a configuration plan and an arrangement plan 3 that are related to the modules and that are included in the pipe information, on the basis of construction information that includes the MTP information, the physical information, the condition information, the process information, the chemical property information, the pipeline information.

The apparatus 1 according to the present disclosure is, for example, a server, and may be used as a Software as a Service (SaaS). In this case, the apparatus 1 is also able to be used for the other users in the service provided in the present disclosure. Therefore, the apparatus 1 according to the present disclosure is also able to construct the configuration plan and the arrangement plan 3 that are related to the modules 2 and that include the pipe information with respect to a plant that is used by the other users.

In the apparatus 1 according to the present disclosure, all of the pipes p each of which connects the modules 2 that are indicated by the configuration plan and the arrangement plan 3 related to the modules are selected. Then, the apparatus 1 specifies the pipe information that is related to all of the pipes p to be placed between the selected modules 2. Moreover, the selection of the pipe p may be performed related to a portion between the modules 2 that has been designated by the user. The pipe information is information that is related to a selection and an arrangement of the pipelines to be placed between the plurality of modules 2, and that includes the quality of a material, the quantity, and the type of each of the pipes p that are suitable for the respective modules 2.

When the apparatus 1 specifies the pipe information, the apparatus 1 determines the pipe p from an already-existing database (DB) related to the pipes p on the basis of the specified pipe information. Then, the apparatus 1 generates an instruction document 4 of the determined pipe p. The instruction document 4 of the generated pipe p may be made available on the web to the worker on a job site, or may be sent through the Internet. In FIG. 1, the instruction document 4 of the pipe p that is needed to connect a module 2-a and a module 2-b is illustrated. As illustrated in FIG. 1, in the instruction document 4, an example in which the pipes p that are needed to connect, for example, the module 2-a and the module 2-b are the pipes indicated by "pipe No. 15, two pipes" and "pipe No. 8, five pipes" are indicated. The worker in the plant refers to this instruction document, and prepares the pipes p that are needed to connect the module 2-a and the module 2-b.

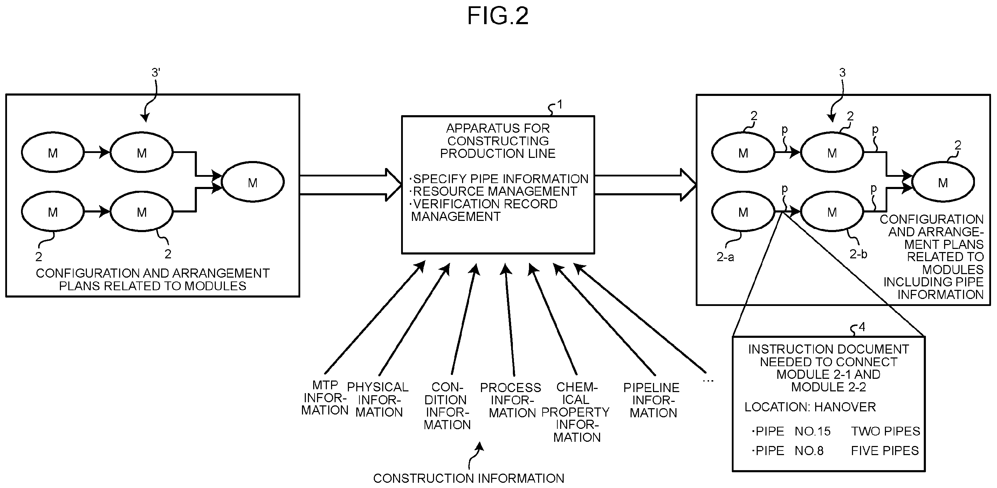

Furthermore, in FIG. 1, the pipe information has been specified with respect to the configuration plan and the arrangement plan 3 that are related to the modules and that have been generated in the apparatus 1, but the apparatus 1 according to the present disclosure may also be able to specify the pipe information on the pipes p each of which connects the modules 2 with respect to a configuration plan and an arrangement plan 3' related to already-existing modules. FIG. 2 is a diagram illustrating the outline of an operation performed with respect to the configuration plan and the arrangement plan 3' that are related to the already-existing modules included in the apparatus 1 according to the embodiment. As illustrated in FIG. 2, the apparatus 1 is able to generate the configuration plan and the arrangement plan 3 that are related to the modules and that include the pipe information with respect to the configuration plan and the arrangement plan 3' related to the already-existing modules.

Furthermore, the apparatus 1 performs resource management and verification record management of a stock of the pipes p. As a result of the apparatus 1 performing the resource management and the verification record management in this way, the apparatus 1 is able to further efficiently reduce the time and the cost needed for a generation process performed in the plant including design, construction, expansion of the plant.

The apparatus 1 according to the present disclosure is able to efficiently reduce the time and the cost needed for a generation process performed in the plant by specifying the pipe information with respect to the configuration plan and the arrangement plan 3 of the modules (including the configuration plan and the arrangement plan 3' of the already-existing modules).

### (2. Embodiment)

The apparatus 1 according to the embodiment specifies the pipe information that is related to the selection and the arrangement of the pipelines to be placed between the modules 2 with respect to the configuration plan and the arrangement plan of the modules that have been generated as indicated in FIG. 1 or with respect to the configuration plan and the arrangement plan 3' of the already-existing modules generated as indicated in FIG. 2, and then, generates the configuration plan and the arrangement plan 3 that are related to the modules and that include the pipe information.

### (2.1. First Embodiment)

### (2.1.1. Configuration)

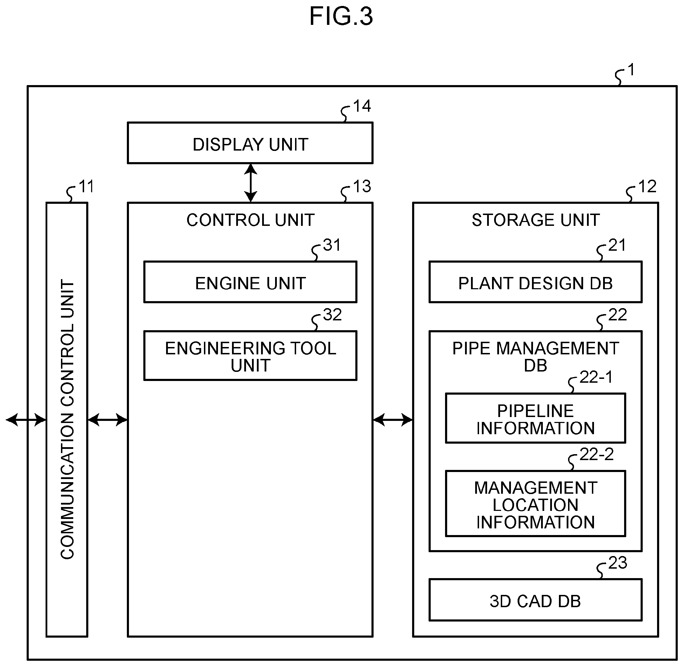

The apparatus 1 according to the first embodiment that generates the configuration plan and the arrangement plan related to the modules, and that has a pipe selection function of performing intelligent selection of the pipes p to be placed between the modules 2 with respect to the generated configuration plan and the arrangement plan related to the module will be described. FIG. 3 is a functional block diagram illustrating a configuration of the apparatus 1 according to the first embodiment. As illustrated in FIG. 3, the apparatus 1 includes a communication control unit 11, a storage unit 12, a control unit 13, and a display unit 14.

### (Communication control unit 11)

The communication control unit 11 manages control of communication between the apparatus 1 and an external device. For example, the communication control unit 11 outputs the instruction document 4 that is related to the pipes p and that corresponds to the pipe information that has been specified by an engine unit 31 included in the apparatus 1. Furthermore, the communication control unit 11 receives the condition information on a production goal or the like transmitted from the outside, and outputs the received condition information to the engine unit 31 included in the control unit 13.

### (Storage unit 12)

The storage unit 12 is a functioning unit that stores therein various kinds of data. The storage unit 12 is provided in the interior of the apparatus 1, but the storage unit 12 may also be implemented by an auxiliary storage that is provided outside of the apparatus 1. The storage unit 12 stores therein a plant design DB 21 that stores therein information related to the modules 2, a pipe management DB 22 that stores therein the information related to the pipes p, and a 3D CAD DB 23.

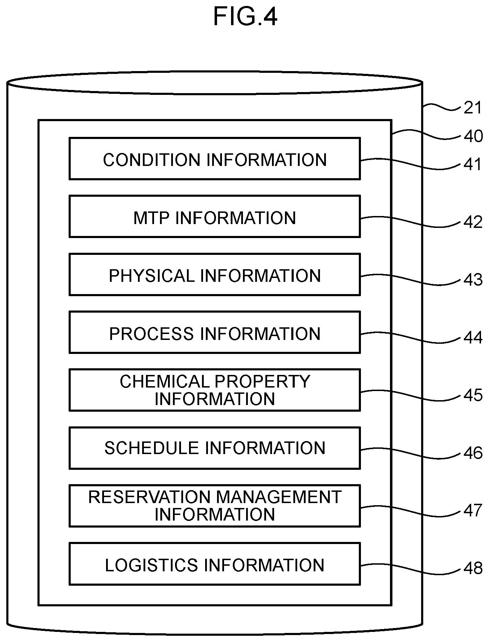

FIG. 4 is a diagram illustrating construction information 40 that is stored in the plant design DB 21 that is included in the apparatus 1 according to the first embodiment. The information stored in the plant design DB 21 includes the information that has been acquired from external information source of the apparatus 1. As illustrated in FIG. 4, the plant design DB 21 stores therein the construction information 40 that is used to construct the production line.

The construction information 40 includes condition information 41, MTP information 42, physical information 43, process information 44, chemical property information 45, schedule information 46, reservation management information 47, and logistics information 48.

The condition information 41 is information that is used at the time of generation of the configuration plan and the arrangement plan 3 that are related to the modules and that include the pipe information related to the modular plant. The condition information 41 includes information indicating that logically constructed production line is able to conform to the physical section in the real plant. The determination whether or not the production line that has been logically constructed conforms to the physical section in the real plant includes determination whether, for example, a space for carrying in a device conforming to the physical section in the real plant is present, and a leading wire for carrying in and out the device is preset.

Furthermore, the condition information 41 includes the information corresponding to a constraint condition and an objective function. For example, the condition information 41 is information that is the constraint condition and that is related to information indicating that, for example, "1. Arrangement of the modules 2 is possible in the designated space in the plant, 2. Taking into consideration of a constraint of a supply chain and logistics, 3. Taking into consideration of availability of the module 2 and schedule management, 4. Maximizing utilization efficiency of the space, 5. Proposal of cost-effective configuration plan and the arrangement plan of the module 2 has been made, 6. The material to be used needs to be able to withstand the chemical properties", and the like.

Furthermore, the condition information 41 is information that is the objective function and that is related to information indicating that, for example, "1. Minimizing energy consumption, 2. Maximizing production efficiency and reducing downtime to a minimum, 3. Reducing an environmental load to a minimum, 4. Reducing recombination work to a minimum and minimizing efforts, 5. Reducing cost needed for line construction to a minimum", and the like.

The condition information 41 includes the information that has been acquired from the information source received from the outside of the apparatus 1 or the information that ahs been input to the apparatus 1. Furthermore, the condition information 41 may also be stored in the plant design DB 21 in advance.

The MTP information 42 is the information that defines the function, the performance, and the interface requirements of the module 2 to be performed on a specific process.

The physical information 43 includes the information on the physical property of the module 2 and the carry in destination of the module 2. The information on the carry in destination of the module 2 is, for example, the size of the floor of the carry in destination of the module 2. Furthermore, the physical information 43 may also include throughput of the module 2, capacity, resource and material efficiency, energy efficiency, electrical power consumption, time needed to provide a service, operating time, an availability of a device, an average failure interval, and a utilization rate of a service and a device.

The process information 44 is information that indicates a process of the configuration plan and the arrangement plan of the module 2 proposed by the modular plant. Information that indicates the maximum carry out volume of the modules 2 may be included in the process information 44. The chemical property information 45 is information that indicates the chemical property of the module 2. The schedule information 46 is information that indicates a production schedule of the module 2. The reservation management information 47 is information that indicates a reservation status of the module 2. The logistics information 48 includes information related to a series of processes starting from the processes of market procurement of the modules 2 or the pipes p, movement of the modules 2 or the pipes p in the plant, production of products starting from the processes of procurement of raw materials, and sales to end consumers to the process of collection and recycling of the modules 2 or the pipes p after use. The market procurement of the modules or the pipes p is performed by purchasing the module at, for example, a shopping site. In the shopping site, the specifications of the module are displayed. In the shopping site, for example, the specifications of a carry out volume, the temperature characteristics, and the like of the modules are displayed.

A description will be given here by referring back to FIG. 3. The pipe management DB 22 stores therein pipeline information 22-1 and management location information 22-2. The pipeline information 22-1 is information related to the pipes p that are used for the modules 2. For example, the pipeline information 22-1 includes the chemical property of the pipeline that is able to withstand the process to be performed, pressure of the pipeline, the material of the pipeline, and the number of pipelines that are needed for the plurality of modules 2 indicated in the configuration plan and the arrangement plan 3 of the module (including the configuration plan and the arrangement plan 3' of the already-existing modules), and the size of the system of the pipelines.

Here, the "pipeline" indicates the route between an input and an output to and from each of the modules 2 indicated in the configuration plan and the arrangement plan 3 (including the configuration plan and the arrangement plan 3' of the already-existing modules) that are related to the modules and that include the pipe information. Therefore, the "number of pipelines" indicates the number of routes indicated in the configuration plan and the arrangement plan 3 (including the already-existing module configuration plan and the arrangement plan 3') that are related to the modules and that include the pipe information.

Furthermore, the "size of the system of the pipeline" to be input includes the diameter of each of the pipelines, the length of each of the pipelines, the number of connection portions, and the like. The diameter is used to select a material having the optimum quality by taking into account the durability and the chemical compatibility on the basis of the type of a fluid, the temperature of the fluid, and the pressure of the fluid. The "length" is used to determine the quantity of the pipes p needed to be used by calculating the length of the needed pipes p on the basis of the distance between the modules 2 and the number of connection points. The "number of connection portions" is used to determine the shape (an L-shape, a straight line, etc.) of each of the pipes p and a connection method (welding, a flange, etc.).

As a result of the "size of the system of the pipelines" being input, the quality of a material, the length, the number of connection portions of the pipelines are specified in detail, which allows for an optimum design of the pipelines. Furthermore, the reason for the need of the "size of the system of the pipelines" is that the diameters of the pipes p that are used for the pipelines and that are able to be connected each of the modules 2 are different, so that there is a need to perform some process, such as a process of using the pipes p each having a different diameter between the pipes p as needed.

The pipeline information 22-1 may also include arrangement information on the optimum pipe p indicated in the configuration plan and the arrangement plan 3 that are related to the module, process information related to joining work of the pipes p, or the like. The management location information 22-2 is information that indicates the management location of the pipes p. The management location may be a single management location in the entire plant, or may be a plurality of management locations. Furthermore, the management location information 22-2 includes the information related to the quality of a material of the pipes p that are managed in the management location, such as a warehouse, the diameter of each of the pipes p, and the shape (an L-shape, a straight line, etc.) of each of the pipes p.

The 3D CAD DB 23 stores therein physical information on a pipe arrangement designed using 3D CAD that is used in combination with the configuration plan and the arrangement plan 3 that are related to the modules and that include the pipe information on the modules 2 or the like displayed on an engineering tool unit 32. The physical information on the pipe arrangement designed using the 3D CAD or the like is used when the configuration plan and the arrangement plan 3 that are related to the modules and that include the pipe information, the pipes p, and the like are displayed in 3D by using an engineering tool unit 25.

### (Control unit 13)

The control unit 13 is a functioning unit that performs the overall control of the apparatus 1. For example, the control unit 13 may be implemented by a hardware processor. The control unit 13 includes the engine unit 31 and the engineering tool unit 32.

### (Engine unit 31)

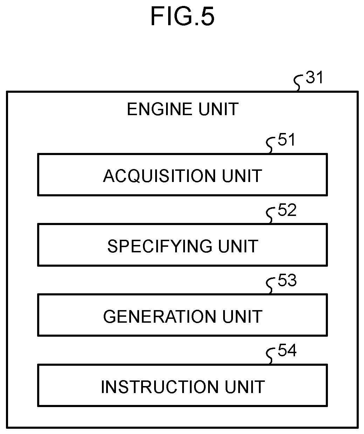

FIG. 5 is a functional block diagram of the engine unit 31 included in the apparatus 1 according to the first embodiment. As illustrated in FIG. 5, the engine unit 31 includes a acquisition unit 51, a specifying unit 52, a generation unit 53, and a instruction unit 54.

The acquisition unit 51 acquires the pipeline information 22-1, the management location information 22-2, the construction information 40, and the like.

The specifying unit 52 specifies the pipe information that is related to the selection and the arrangement of the pipelines to be placed between the plurality of modules 2 on the basis of the acquired construction information 40, the pipeline information 22-1, and the management location information 22-2. Specifically, the specifying unit 52 specifies the pipe information in accordance with the number of pipelines and the size of the system of the pipelines included in the pipeline information 22-1.

Furthermore, the specifying unit 52 specifies pipe information 70 that includes the quality of a material of each of the pipes p suitable for the corresponding modules 2, the quantity of the pipes p, and the type of the pipes p and that conforms to the construction information 40 that includes the physical information 43 and the chemical property information 45.

For example, the specifying unit 52 specifies the material of each of the pipes p that are able to be used for the process to be performed from the chemical property information 45 that is included in the construction information 40 (specifying determination). After that, the specifying unit 52 decides the pipeline system of the pipes p on the basis of the configuration plan and the arrangement plan 3 that are related to the modules (including the configuration plan and the arrangement plan 3' related to the already-existing modules) and on the basis of the construction information 40 (system decision). In the following, the specifying unit 52 decides, regarding the decided pipeline system, the number of pipes p and the type of each of the pipes p on the basis of the arrangement information that is related to the optimum pipes p indicated in the configuration plan and the arrangement plan 3 of the modules and that is included in the pipeline information 22-1 (decision of the number of pipes and the type of pipes). After that, the specifying unit 52 determines the delivery efficiency of the pipe p on the basis of the information that is related to the quality of a material of each of the pipes p, the diameter of each of the pipes p, and the shape of each of the pipes p (an L-shape or a straight line) and that is included in the management location information 22-2, and then outputs the quality of a material of each of the pipes p, the quantity of the pipes p, and the type of each of the pipes p in the optimum pipeline having high delivery efficiency (efficiency determination). As a result of this, the specifying unit 52 is able to specify the pipe information 70 including the quality of a material of each of the pipes p, the quantity of the pipes p, and the type of each of the pipes p placed in the pipelines suitable for the configuration plan and the arrangement plan 3 of the modules.

The generation unit 53 generates the instruction document 4 of the pipes p that are needed to be held in accordance with the management location information 22-2. In a case where a plurality of management locations indicated by the management location information 22-2 are present, the instruction document 4 of the pipes p may be generated for each management location. The generated instruction document may be made available on the web to the worker, or may be sent through the Internet.

The instruction unit 54 outputs a joining instruction of the pipes p after having generated the instruction document 4. The joining instruction may be given after having prepared the pipes p by reading a preparation status of the pipes p at the site of the plant by using the RFID or the bar code that is attached on the pipe p.

The engine unit 31 generates the configuration plan and the arrangement plan 3 that are related to the modules and that include the pipe information, a process flow plan, a production schedule plan of the products, or the like on the basis of the construction information 40, the pipeline information 22-1, and the management location information 22-2. Specifically, the construction information 40 is the condition information 41, the MTP information 42 on the modules 2, the physical information 43, the process information 44, the chemical property information 45, the schedule information 46, the reservation management information 47, and the logistics information 48.

Furthermore, the physical information on the 3D CAD selected from a 3D CAD DB 26 is input to the engine unit 31.

The engine unit 31 may also be an AI model or a simulator that outputs the process flow plan and the production schedule plan that agree with both of the configuration plan and the arrangement plan 3 that are related to the module and that include the pipe information and the condition information 41. Here, the physical information indicated by the 3D CAD is the 3D physical information on the pipe arrangement or the like stored in the 3D CAD DB 23. The physical information indicated by the 3D CAD is output to the engine unit 31 by the engineering tool unit 32.

The constraint condition, the objective function, the process of the algorithm, and the outputs that are output from the engine unit 31 are as follows:

### (Constraint condition)

Examples of the constraint condition include the constraint condition described below.
1. Arrangement of the modules 2 is possible in the designated space in the plant,
2. Taking into consideration of a constraint of a supply chain and logistics,
3. Taking into consideration of availability of the module 2 and schedule management,
4. Maximizing utilization efficiency of the space,
5. Proposal of cost-effective configuration plan and the arrangement plan that is related to the module 2 and that include the pipe information has been made, and
6. The material to be used needs to be able to withstand the chemical property.

Among the above described constraint conditions, a predetermined constraint condition may be an essential item. For example, among the above described constraint conditions, the constraint conditions of "4. Maximizing utilization efficiency of the space, 5. Proposal of cost-effective configuration plan and the arrangement plan that is related to the module 2 and that include the pipe information has been made, and 6. The material to be used needs to be able to withstand the chemical property" may be the essential items for the constraint condition.

### (Relationship between the pipeline information 22-1 and constraint condition)

In the following, an example of the relationship between the pipeline information 22-1 and the constraint condition will be described. For example, the number of pipelines indicated in the pipeline information 22-1 is decided on the basis of the following constraint condition.

### Arrangement constraint:

The arrangement constraint of the pipeline information 22-1 is included in the constraint condition of "1. Arrangement of the modules 2 is possible in the designated space in the plant" from among the above described constraint conditions. The number of pipelines indicated in the pipeline information 22-1 is able to be determined on the basis of the arrangement constraint. For example, in a case where there is an arrangement constraint indicating that the pipeline needs to pass through a specific path, the number of pipelines suitable for the specific path is calculated.

### Physical constraint:

The physical constraint related to the pipeline information 22-1 is included in the constraint condition of "1. Arrangement of the modules 2 is possible in the designated space in the plant" from among the above described constraint conditions. The number of pipelines is able to be determined on the basis of the physical constraint. The physical constraint is used in a case where, for example, interference between the space of a factory and already-existing equipment needs to be avoided. The number of pipelines is determined on the basis of the above described physical constraints. As a result of this, the optimum number of pipelines that are able to be used in the available space is determined.

### Safety constraint:

A safety constraint related to the pipeline information 22-1 is included in the constraint condition of "6. The material to be used needs to be able to withstand the chemical property" from among the above described constraint conditions. The number of pipelines is able to be determined on the basis of a safety constitution. The safety constraint is a safety constraint of a restriction on, for example, a pressure, a temperature, or the like. The number of pipelines is determined with a certain safety margin on the basis of the above described safety constraint.

### (Objective function)

In the following, an objective function will be described. The objective function includes, for example, the objective functions described below.
1. Minimizing energy consumption
2. Maximizing production efficiency and reducing downtime to a minimum
3. Reducing an environmental load to a minimum
4. Reducing recombination work to a minimum and minimizing efforts
5. Reducing cost needed for line construction to a minimum

### (Relationship between the pipeline information 22-1 and objective function)

An example of the relationship between the pipeline information 22-1 and the objective function will be described. For example, the size of the system of the pipelines indicated in the pipeline information 22-1 is decided on the basis of the objective function described below.

### Production efficiency:

The production efficiency indicated in the pipeline information 22-1 is included in the objective function of "1. Minimizing energy consumption" from among the above described objective functions. The size of the system of the pipelines is able to be determined on the basis of the production efficiency. As the production efficiency, in a case where optimization of a flow rate or a pressure is defined as the objective function, the diameter or the length of each of the pipelines in the size of the system of the pipelines indicated in the pipeline information 22-1 is appropriately selected. As a result of this, it is possible to perform efficient production.

### Cost constraint:

The cost constraint related to the pipeline information 22-1 is included in the objective function of "5. Reducing cost needed for line construction to a minimum" from among the above described objective functions. The size of the system of the pipelines is able to be determined on the basis of the cost constraint. As the cost constraint, in a case where minimization of the cost is defined as the objective function, the optimum size of the system of the pipelines is determined by taking into consideration the material expenses of the modules 2 and installation cost.

### Ease of maintenance:

Ease of maintenance related to the pipeline information 22-1 is included in the objective function of "4. Reducing recombination work to a minimum and minimizing efforts" from among the above described objective functions. The size of the system of the pipelines is able to be determined on the basis of the ease of maintenance. As the ease of maintenance, in a case where ease of maintenance and repair is defined as the objective function, the arrangement and the size of the pipelines are optimized, and the size of the system of the pipelines is determined.

The size of the system of the pipeline to be indicated in the pipeline information 22-1 is specifically determined on the basis of the above described objective functions, and an optimum production line is constructed.

### (Process of algorithm)

In the following, the process of the algorithms will be described. The process of the algorithms is, for example, as follows.
1. Acquire information from the plant design DB 21, the pipe management DB 22, and the 3D CAD DB 23 and select an optimum pipeline.
2. Calculate an optimum combination of the modules 2 using the optimization algorithm.
3. Automatically generate an optimum arrangement plan of the modules 2 and a selection of the pipes.

### (Output)

The outputs are as follows.
1. A configuration plan of the selected pipes p.
2. Recommended process flow and production schedule.
3. Optimum production line arrangement based on consideration of space efficiency, an environmental load, and cost.

For example, for the algorithm for selecting the pipeline indicated by "1. Acquire information from the plant design DB 21, the pipe management DB 22, and the 3D CAD DB 23 and select an optimum pipeline." included in the above described algorithms, the physical information 43, the chemical property information 45, the pipeline information 22-1, and the management location information 22-2 that are included in the construction information 40 are used.

For example, the condition information 41, the MTP information 42 on the modules 2, the physical information 43, the process information 44, the chemical property information 45, the schedule information 46, the reservation management information 47, and the logistics information 48 that are included in the construction information 40 are used for the process of the algorithm indicated by "2. Calculate an optimum combination of the modules 2 using the optimization algorithm." from among the above described processes of the algorithms.

Furthermore, the pipeline information 22-1 and the management location information 22-2 is used to "3. Automatically generate an optimum arrangement plan of the modules 2 and a selection of the pipe p." from among the above described processes of the algorithms.

For example, the engine unit 31 uses the pipeline information 22-1 for the objective functions of the "4. Minimizing recombination work to minimize efforts" and "5. Reducing cost needed for line construction to a minimum". Furthermore, the engine unit 31 uses the pipeline information 22-1 for the constraint conditions indicated by "5. Proposal of cost-effective configuration plan and the arrangement plan that are related to the module and that include the pipe information has been made", and "6. The material to be used needs to be able to withstand the chemical property".

In the above described processes of the algorithm indicated by "2. Calculate an optimum combination of the modules 2 using the optimization algorithm." and "3. Automatically generate an optimum arrangement plan of the modules 2 and a selection of the pipes p.", in a case where, for example, the engine unit 31 selects an optimum combination from among the modules 2 that are able to be used, the engine unit 31 performs the process of the algorithm indicated by "2. Calculate an optimum combination of the modules 2 using the optimization algorithm.", and uses the information that indicates the configuration of the module 2 indicated by the condition information 41 included in the subject algorithms. Therefore, the apparatus 1 according to the first embodiment is able to select an optimum combination of the modules 2 that agrees with the condition information 41.

Furthermore, for example, in a case where the arrangement plan related to the modules 2 is generated, there is a need to use the condition that is used at the time of generation of the arrangement plan related to the modules 2 provided in the modular plant. The engine unit 31 uses the arrangement plan indicated by the condition information 41 and the pipeline information 22-1 when process of the algorithm indicated by [3. Automatically generate an optimum arrangement plan of the modules 2 and a selection of the pipes p.] is performed. Therefore, the apparatus 1 according to the first embodiment is able to propose an optimum arrangement of the modules 2 that agrees with the condition information 41 and the pipeline information 22-1.

Furthermore, in a case where the construction plan of the production line is generated, there is a need to carry in the modules 2 into the site. The physical information 43 includes the information on the carry in destination of the modules 2. In a case where the construction plan of the production line is generated, the information on the carry in destination of the module 2 is needed. The engine unit 31 uses the information on the carry in destination of the modules 2 indicated by the physical information 43 when the engine unit 31 performs the process of the algorithm indicated by "3. Automatically generate an optimum arrangement plan of the modules 2 and a selection of the pipe p.". The apparatus 1 according to the first embodiment is able to generate the construction plan of the production line conforming to the real plant by using the physical information 43.

In addition, for example, in order to generate an optimum process flow, there is a need to grasp the process information 44 on the modules 2 in the plant, the chemical property information 45, the schedule information 46, the reservation management information 47, and the logistics information 48. For example, the engine unit 31 is able to generate a safe process flow by using the chemical property information 45 in which non-flammability or the like is defined. Similarly, the engine unit 31 is able to generate the process flow to be completed within a week by using the schedule information 46 in which within a week or the like is defined, the engine unit 31 is able to generate the process flow by using the modules 2 that are able to be used within a reservation period by using the reservation management information 47 in which a period of time between mm/dd (mm: month, and dd: date) and mm/dd has been defined, and the engine unit 31 is able to generate the process flow in consideration of a delivery period of the plant by using the logistics information 48 in which two days or the like is defined as the delivery period of the plant.

When the engine unit 31 performs the process of the algorithm indicated by "3. Automatically generate an optimum arrangement plan of the modules 2 and a selection of the pipes p.", the engine unit 31 uses the process information 44, the chemical property information 45, the schedule information 46, the reservation management information 47, and the logistics information 48. The apparatus 1 according to the first embodiment is able to propose an optimum process flow conforming to the real plant by using the process information 44, the chemical property information 45, the schedule information 46, the reservation management information 47, and the logistics information 48 that are included in the construction information 40.

Furthermore, the engine unit 31 is also able to construct a production line having high productivity on the basis of the information that indicates the maximum carry out volume of the modules 2 and that is included in the process information 44. In this case, the information that indicates the maximum carry out volume is used in the process related to the operating efficiency of the objective function and the constraint condition. For example, in a case where a production line that has been constructed by the module 2-a to a module 2-x and in a case where only the maximum carry out volume of the module 2-b is extremely small, the operation rate of the subject production line reaches the ceiling at the maximum carry out volume indicated by B. In a case where, for example, the constraint condition or the objective function is set to "maximize the operating efficiency", the engine unit 31 constructs the production line such that a difference of the maximum carry out volume between the modules 2 does not become large on the basis of the information that indicates the maximum carry out volume of the modules 2 included in the process information 44. Therefore, the apparatus 1 according to the embodiment does not construct an inefficient production line by using the information that indicates the maximum carry out volume.

In other words, the engine unit 31 generates the configuration plan and the arrangement plan of the modules 2 so as to satisfy the constraint condition and also satisfy the objective function (condition information)), and outputs the specific information on the selected pipe p that is located between the modules 2 by using the pipeline information 22-1 or the like with respect to the generated configuration plan and the arrangement plan of the modules 2.

In other words, the engine unit 31 uses the construction information 40 that is stored in the plant design DB 21 and uses the pipeline information 22-1 and the management location information 22-2 that are stored in the pipe management DB 22 to perform the process of the algorithms.

### (Engineering tool unit 32)

The engineering tool unit 32 is a functioning unit that is used when the modular plant is designed. For example, the engineering tool unit 32 inputs the condition information 41 that is input from the user, the pipeline information 22-1 on the plant, or the like. Furthermore, the engineering tool unit 32 displays the configuration plan and the arrangement plan 3 that are related to the modules and that include the pipe information on the display unit 14 by using 3D CAD, or the like.

### (Display unit 14)

The display unit 14 is a functioning unit that displays various kinds of information. As one example, the display unit 14 may be implemented by a liquid crystal display, an organic electro luminescence (EL) display, or the like. On the display unit 14, the configuration, the arrangement, or the like of the module 2 including the pipe information that has been generated by the engineering tool unit 32 is displayed.

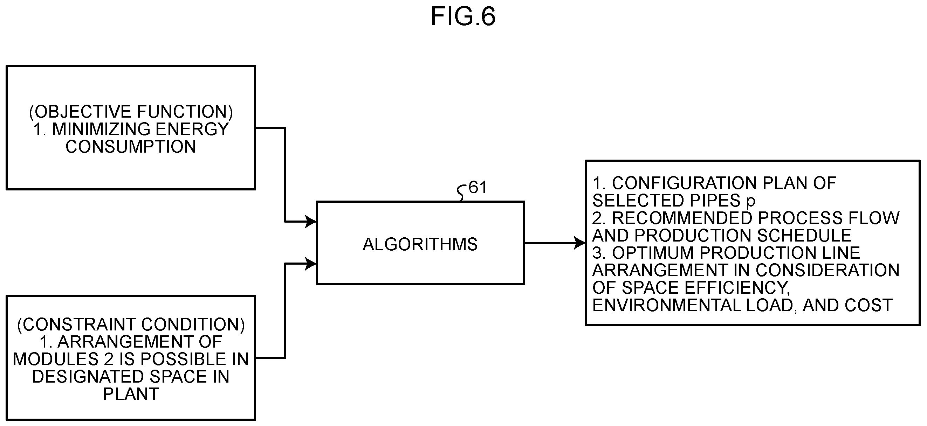

FIG. 6 is a diagram illustrating a first example of the relationship between the objective function and the constraint condition of an algorithm 61 and an output indicated in the apparatus 1 according to the first embodiment. As illustrated in FIG. 6, for example, as the objective function, "1. Minimizing energy consumption" is input to the algorithm 61 defined in the engine unit 31 and, as the constraint condition, "1. Arrangement of the modules 2 is possible in the designated space in the plant" is input to the algorithm 61 defined in the engine unit 31. Then, the algorithm 61 outputs information indicating "1. A configuration plan of the selected pipes p, 2. Recommended process flow and production schedule, and 3. An optimum production line arrangement in consideration of space efficiency, an environmental load, and cost".

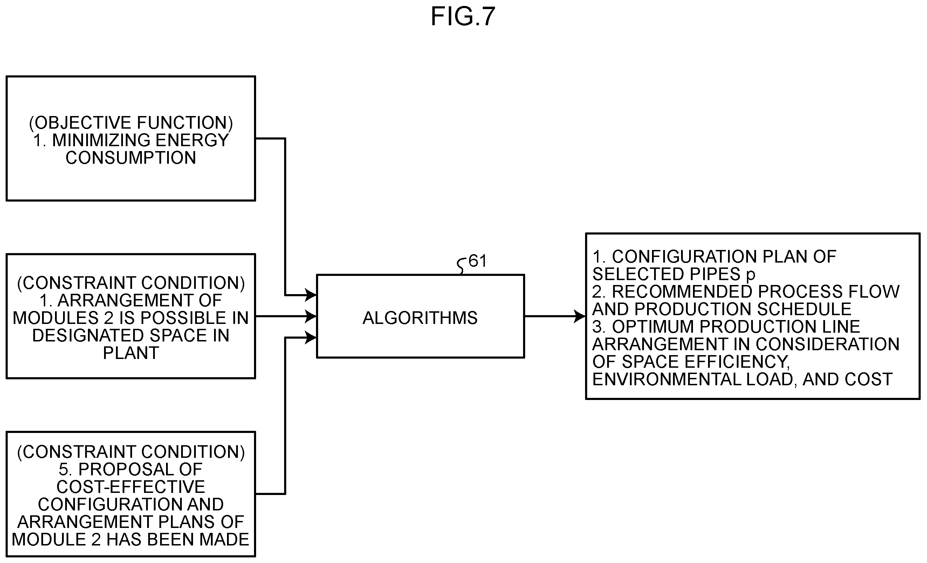

FIG. 7 is a diagram illustrating a second example of the relationship between objective function and the constraint condition of the algorithm 61 and an output indicated in the apparatus 1 according to the first embodiment. As illustrated in FIG. 7, for example, as objective function, "1. Minimizing energy consumption" is input to the algorithm 61 defined in the engine unit 31, as the constraint condition, "1. Arrangement of the modules 2 is possible in the designated space in the plant" and "5. Proposal of cost-effective configuration plan and the arrangement plan of the module 2 has been made" are input to the algorithm 61 defined in the engine unit 31. Then, the algorithm 61 outputs information indicating "1. A configuration plan of the selected pipes p, 2. Recommended process flow and production schedule, and 3. An optimum production line arrangement in consideration of space efficiency, an environmental load, and cost".

In other words, the algorithm 61 outputs different results in accordance with the input constraint condition and the input objective function. Moreover, regarding the objective function, a plurality of inputs are also able to be performed.

### (Pipe information 70)

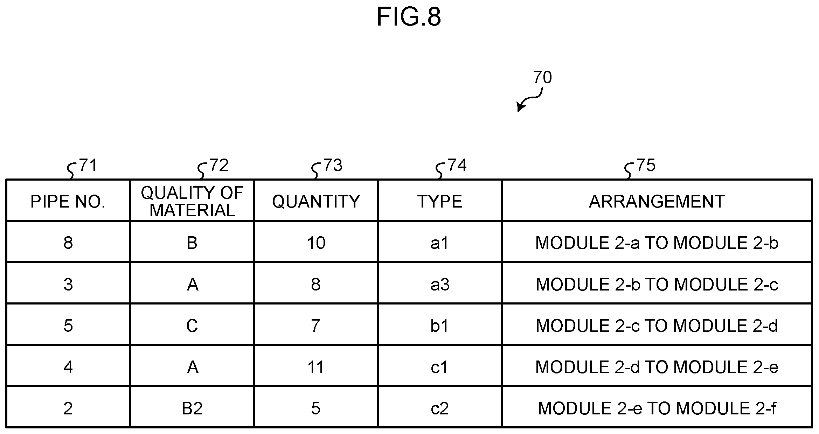

FIG. 8 is a diagram illustrating the pipe information 70 specified in the apparatus 1 according to the first embodiment. As illustrated in FIG. 8, the pipe information 70 is information related to a selection and an arrangement of the pipelines that are to be placed between the modules 2.

As illustrated in FIG. 8, the pipe information 70 includes a pipe number 71, a quality of a material 72, a quantity 73, a type 74, and an arrangement 75. For example, in FIG. 8, it is indicated that a pipe having a pipe number of 8 with a quality of a material of B, a quantity of 10, and a type of a1 is arranged between the module 2-a and the module 2-b. Furthermore, it is indicated that a pipe having a pipe number of 3 with a quality of a material of A, a quantity of 8, and a type of a3 is arranged between the module 2-b and a module 2-c. Furthermore, it is indicated that a pipe having a pipe number of 5 with a quality of a material of C, a quantity of 7, and a type of b1 is arranged between the module 2-c and a module 2-d. Furthermore, it is indicated that a pipe having a pipe number of 4 with a quality of a material of A, a quantity of 11, and a type of c1 is arranged between the module 2-d and a module 2-e. Furthermore, it is indicated that a pipe having a pipe number of 2 with a quality of a material of B2, a quantity of 5, and a type of c2 is arranged between the module 2-e and a module 2-f.

### (Selection of constraint condition)

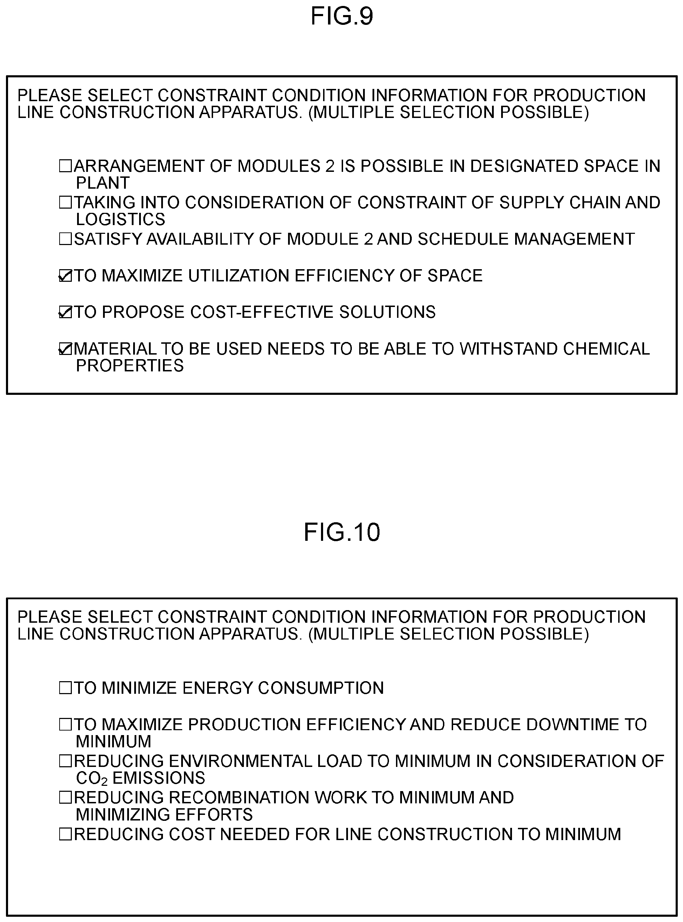

FIG. 9 is a diagram illustrating one example of a screen that is used to input the constraint condition information that is provided in the apparatus 1 according to the first embodiment. As illustrated in FIG. 9, the user of the apparatus 1 selects an object of the production line to be constructed.

In the example illustrated in FIG. 9, at least one of the items from among the items of 1. Arrangement of the modules 2 is possible in the designated space in the plant, 2. Taking into consideration of a constraint of a supply chain and logistics, 3. Satisfy availability of the module 2 and schedule management, 4. Maximizing utilization efficiency of the space, 5. To propose cost-effective solutions, and 6. The material to be used needs to be able to withstand the chemical properties.

Moreover, in FIG. 9, regarding the items of "4. Maximizing utilization efficiency of the space, 5. To propose cost-effective solutions, and 6. The material to be used needs to be able to withstand the chemical properties", a case in which the items have been set as the essential selection item is illustrated. In this way, the apparatus 1 may also set a predetermined constraint condition as the essential selection item from among the items of the plurality of constraint conditions.

### (Selection of objective function)

FIG. 10 is a diagram illustrating one example of a screen that is used to input the objective function information that is provided in the apparatus 1 according to the first embodiment. As illustrated in FIG. 10, the user of the apparatus 1 selects an object of the production line to be constructed.

In the example illustrated in FIG. 10, at least one objective item of the items from among the items of 1. Minimizing energy consumption, 2. Maximizing production efficiency and reducing downtime to a minimum, 3. Reducing an environmental load to a minimum in consideration of CO₂ emissions, 4. Reducing recombination work to a minimum and minimizing efforts, and 5. Reducing cost needed for line construction to a minimum.

Regarding the selection of the objective function, similarly to the selection of the constraint condition, the apparatus 1 may also set a predetermined objective function as the essential selection item from among the items of the plurality of objective functions.

### (Configuration plan and the arrangement plan 3 related to modules including pipe information)

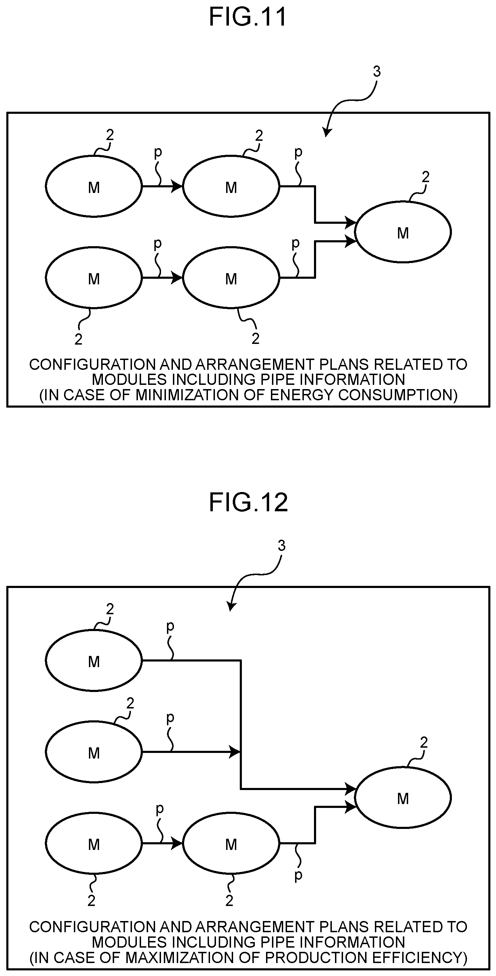

FIG. 11 is a diagram illustrating one example of the configuration plan and the arrangement plan 3 that are related to the modules and that include the pipe information in a case where energy consumption is minimized. As illustrated in FIG. 11, in the configuration plan and the arrangement plan 3 that are related to the modules and that include the pipe information, "in a case of minimization of energy efficiency" is illustrated together with the configuration plan and the arrangement plan 3 that are related to the modules and that include the pipe information. Furthermore, in the configuration plan and the arrangement plan 3 that are related to the modules and that include the pipe information, the pipes p between the modules 2 are specified by the pipe information 70.

FIG. 12 is a diagram illustrating one example of the configuration plan and the arrangement plan 3 that are related to the modules and that include the pipe information in a case where production efficiency is maximized. As illustrated in FIG. 12, in the configuration plan and the arrangement plan 3 that are related to the modules and that include the pipe information, "in a case of maximization of production efficiency " is illustrated together with the configuration plan and the arrangement plan 3 that are related to the modules and that include the pipe information. In this way, by clearly displaying the configuration plan and the arrangement plan 3 that are related to the modules and that include information indicating what purpose the pipe information has been generated for, the user is able to check the configuration plan and the arrangement plan 3 that are related to the modules and that include the pipe information in accordance with the object. Furthermore, in the configuration plan and the arrangement plan 3 that are related to the modules and that include the pipe information, the pipes p that are placed between the modules 2 are specified by the pipe information 70.

### (Instruction document 4)

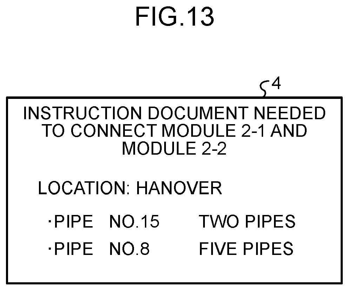

In the following, the instruction document 4 that is generated by the apparatus 1 will be described. FIG. 13 is a diagram illustrating an example of the instruction document 4 of the pipes p that are needed to connect the module 2-a and the module 2-b.

As illustrated in FIG. 13, it is instructed that, in the instruction document 4 of the pipes p that are needed to connect the module 2-a and the module 2-b, for example, in the location of Hanover, two pipes p with the pipe number of 15 are needed and five pipes p with the pipe number of 8 are needed.

The instruction document 4 is generated by the generation unit 53 such that the worker located at the site is able to view the instruction document 4. The worker refers to the instruction document 4, and prepares the needed pipes p at the location that has been instructed by the instruction document 4.

### (2.1.2. Operation)

In the following, an operation of the apparatus 1 performed in the modular plant according to the first embodiment will be described.

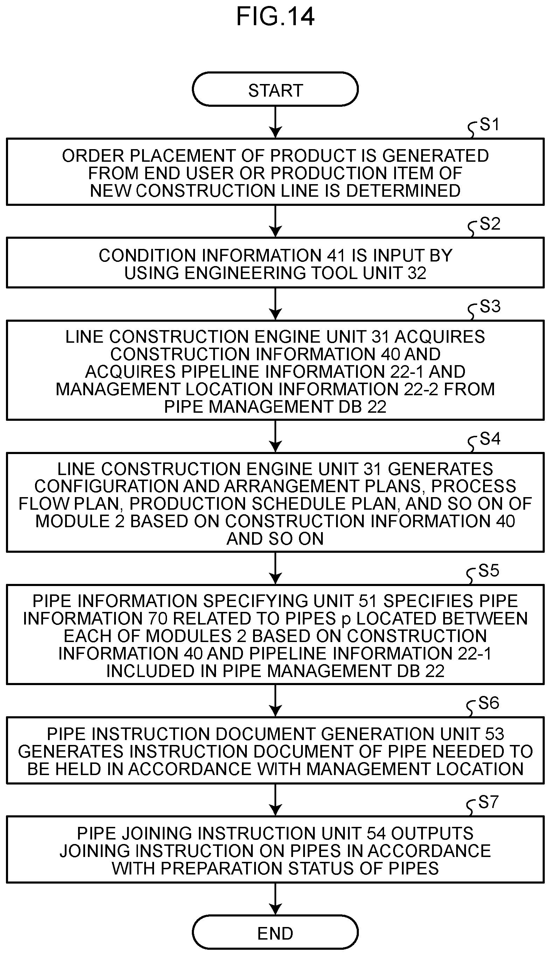

FIG. 14 is a flowchart illustrating an operation of the apparatus 1 according to the first embodiment. As illustrated in FIG. 1, an order placement of the product is generated from an end user or a production item of a new construction line is determined (Step S1).

Then, a designer of the modular plant corresponding to the user inputs the condition information 41 by using the engineering tool unit 32 at the time of a launch of a new project of a change in the production line (Step S2).

The engine unit 31 acquires the construction information 40 from the plant design DB 21 and acquires the pipeline information 22-1 and the management location information 22-2 and the pipe management DB 22 (Step S3).

Then, the engine unit 31 generates configuration plan and the arrangement plan, the process flow plan, the production schedule plan, or the like of the module 2 on the basis of the construction information 40 (Step S4).

Then, the specifying unit 52 specifies the pipe information 70 that is related to the pipes p located between each of the modules 2 on the basis of the construction information 40 with respect to the configuration plan and the arrangement plan of the modules 2 and the pipeline information 22-1 included in the pipe management DB 22 (Step S5).

After that, the generation unit 53 generates the instruction document of the pipe needed to be held in accordance with the management location that is indicated by the management location information 22-2 (Step S6).

Then, the instruction unit 54 outputs the joining instruction on the pipe in accordance with the preparation status of the pipes (Step S7), and ends the process.

Moreover, the apparatus 1 according to the first embodiment is able to omit the process performed at Step S4 in a case where the pipe information 70 on the pipes p is specified with respect to the configuration plan and the arrangement plan 3' of the already-existing modules. In other words, as illustrated in FIG. 2, the apparatus 1 according to the first embodiment is able to specify the pipe information with respect to the configuration plan and the arrangement plan 3' of the already-existing modules. The same applies to an apparatus 101 according to a second embodiment and an apparatus 201 according to a third embodiment that will be described later.

### (2.1.3. Effects)

Therefore, the apparatus 1 according to the first embodiment is able to improve the efficiency and the accuracy of the selection of the pipes p. In other words, the apparatus 1 according to the first embodiment automatically selects the information of the pipes p, so that the worker is able to promptly and accurately an optimum pipe p. As a result of this, the production efficiency of the production line is improved, and the risk of a human error is reduced.

Furthermore, the apparatus 1 according to the first embodiment specifies the pipe information 70 in accordance with the number of pipelines and the size of the system of the pipelines that are needed for the module 2 and that are included in the pipeline information 22-1, so that the apparatus 1 is able to obtain the pipe information 70 according to the instruction received from the user.

In addition, the apparatus 1 according to the first embodiment specifies the pipe information 70 including the quality of a material of each of the pipes p, the quantity of the pipes p, and the type of each of the pipes p that are suitable for the modules 2 on the basis of the construction information 40 related to the modules 2, so that the apparatus 1 is able to select the pipes p suitable for the production line.

In addition, the apparatus 1 according to the first embodiment generates the instruction document of the pipes p that are needed to be held in accordance with the management location information 22-2, so that the apparatus 1 is able to appropriately generate the instruction document of the pipes p.

In addition, after having generated the instruction document, the apparatus 1 according to the first embodiment is able to efficiently reduce the time and the cost needed for a generation process performed in the plant by outputting the joining instruction of the pipes.

In addition, in the apparatus 1 according to the first embodiment, the joining instruction is performed on the basis of the preparation status that is related to the pipes p that have been read form the RFID or the bar code attached to the pipe p. Therefore, the apparatus 1 according to the first embodiment is able to efficiently reduce the time and the cost needed for a generation process performed in the plant by outputting the joining instruction of the pipes.

### (2.2. Second Embodiment)

In the following, the apparatus 101 according to the second embodiment will be described. The apparatus 101 according to the second embodiment tracks the joining history of the pipes p or the status of use of the pipes p, and performs dynamic resource management of a stock of the pipes p in real time.

In other words, in a case where the joining history of the pipes p or the status of use of the pipes p has been changed in the apparatus 1 according to the first embodiment, the apparatus 101 according to the second embodiment has a function of changing a resource allocation of the stock of the pipes p.

### (2.2.1. Configuration)

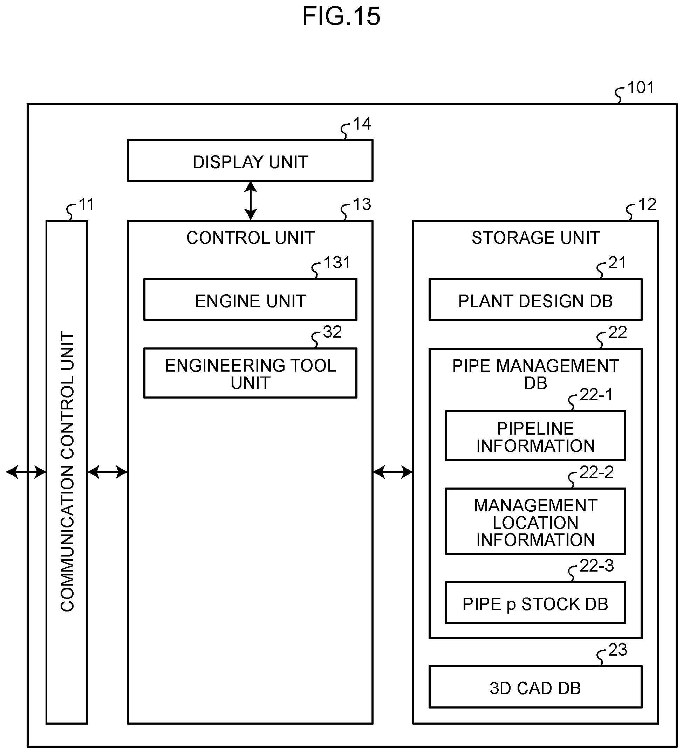

FIG. 15 is a functional block diagram illustrating the function of the apparatus 101 according to the second embodiment. Moreover, components that are the same as those illustrated in FIG. 3 are assigned the same reference numerals and descriptions thereof will be omitted, and, here, a part that is different from that described above with reference to FIG. 3 will be described.

As illustrated in FIG. 15, the pipe management DB 22 included in the storage unit 12 includes a pipe p stock DB 22-3 of the pipes p. The pipe p stock DB 22-3 is a DB that manages the stock of the pipe p. The pipe p stock DB 22-3 manages, for example, the number assigned to each of the pipes p, the type of each of the pipes p, the quantity of the pipe p, and the material of each of the pipes p.

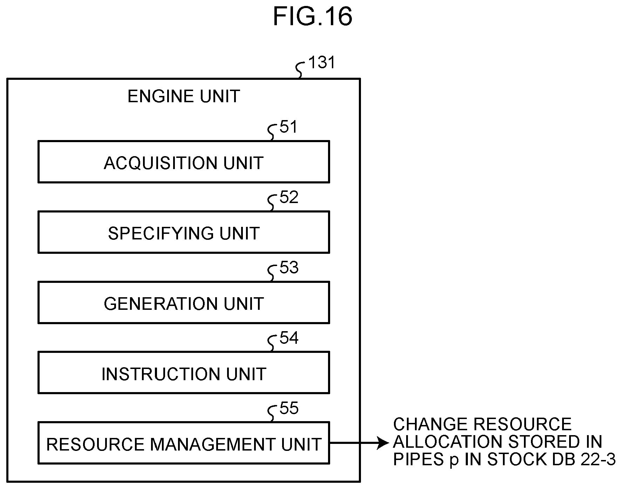

FIG. 16 is a functional block diagram of the engine unit 131 included in the apparatus 101 according to the second embodiment. In FIG. 16, a description will be given by assigning the same reference numerals to components having the same configuration illustrated in FIG. 5.

In a case where the joining history of the pipe p or the status of use of the pipes p has been changed, a resource management unit 55 changes the stock of the pipes p stored in the pipe p stock DB 22-3. The joining history of the pipe p or the status of use of the pipes p is grasped in real time by reading, for example, the RFID or the bar code attached to the connected pipe p.

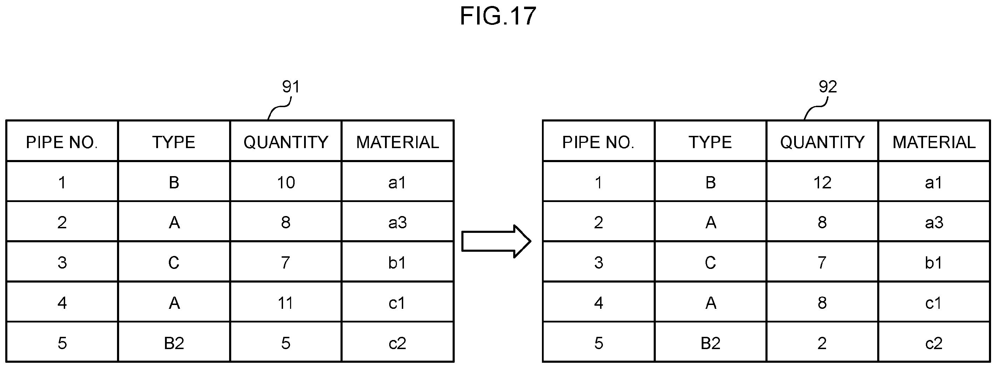

FIG. 17 is a diagram illustrating a first example of a resource allocation of a stock before change 91 and a resource allocation of a stock after change 92 in the apparatus 101 according to the second embodiment. FIG. 17 illustrates a case in which a quantity 10 of the pipes p that has the pipe number of 1 and that is indicated when the stock before change 91 has been changed to a quantity 12 of the pipes p that is indicated when the stock after change 92, and a quantity 11 of the pipes p that has the pipe number of 4 and that is indicated when the stock before change 91 has been changed to a quantity 8 of the pipes p that is indicated when the stock after change 92.

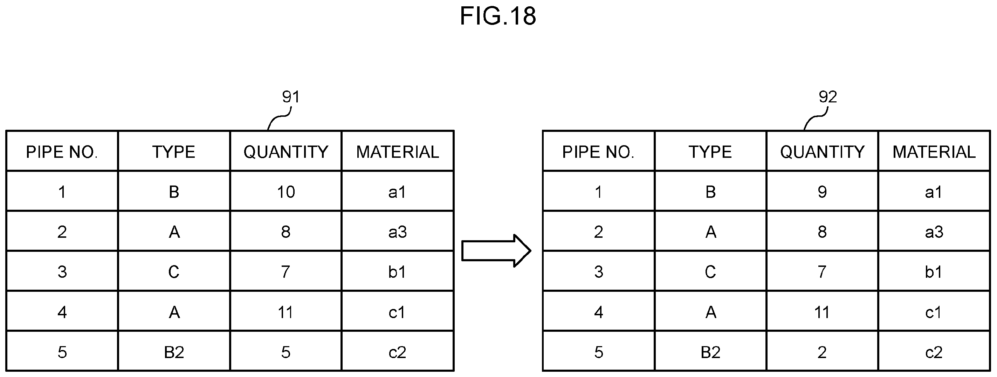

FIG. 18 is a diagram illustrating a second example of a resource allocation of the stock before change 91 and a resource allocation of the stock after change 92 in the apparatus 101 according to the second embodiment. FIG. 18 illustrates a case in which the quantity 10 of the pipes p that has the pipe number of 1 and that is indicated when the stock before change 91 has been changed to a quantity 9 of the pipes p that is indicated when the stock after change 92.

In this way, in a case where the joining history of the pipes p or the status of use of the pipes p has been changed, the resource management unit 55 flexibly changes the resource allocation of the pipes p in the pipe p stock DB 22-3.

### (2.2.2. Operation)

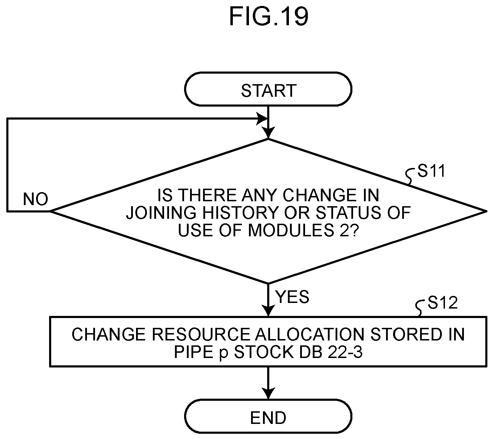

In the following, an operation of the apparatus 101 according to the second embodiment will be described. FIG. 19 is a flowchart illustrating an operation of the apparatus 101 according to the second embodiment.

As illustrated in FIG. 19, the resource management unit 55 determines whether there is a change in the joining history or the status of use of the modules 2 (Step S11), and if there is no changed in the joining history or the status of use of the modules 2 (No at Step S11), the resource management unit 55 continues the process at Step S11.

In contrast, if there is a change in the joining history or the status of use of the modules 2 (Yes Step S11), the resource management unit 55 changes the resource allocation of the pipes p stored in the pipe p stock DB 22-3 (Step S12), and ends the process.

### (2.2.3. Effects)

Therefore, the apparatus 101 according to the second embodiment immediately identifies the joining history of the pipes p and the status of use of the pipes p that are needed to connect the modules 2, and changes the resource allocation of the pipes p, so that the apparatus 101 is able to provide dynamic resource management to enhance the efficiency and the flexibility of the production line.

Furthermore, the apparatus 101 according to the second embodiment monitors the status of use of the parts that are needed to connect the modules 2 in real time, and is able to reallocate the resource of the pipes p as needed.

In addition, the apparatus 101 according to the second embodiment is able to reduce the risk of an excessive stock or an insufficient stock, and is able to contribute to a cost reduction. In other words, the apparatus 101 according to the second embodiment is able to optimize the resource management of the pipes p.

### (2.3. Third Embodiment)

In the following, the apparatus 201 according to the third embodiment will be described. The apparatus 201 according to the third embodiment records process information that is related to the joining work of the pipes p, and strengthens the quality management of the plant and a verification process.

### (2.3.1. Configuration)

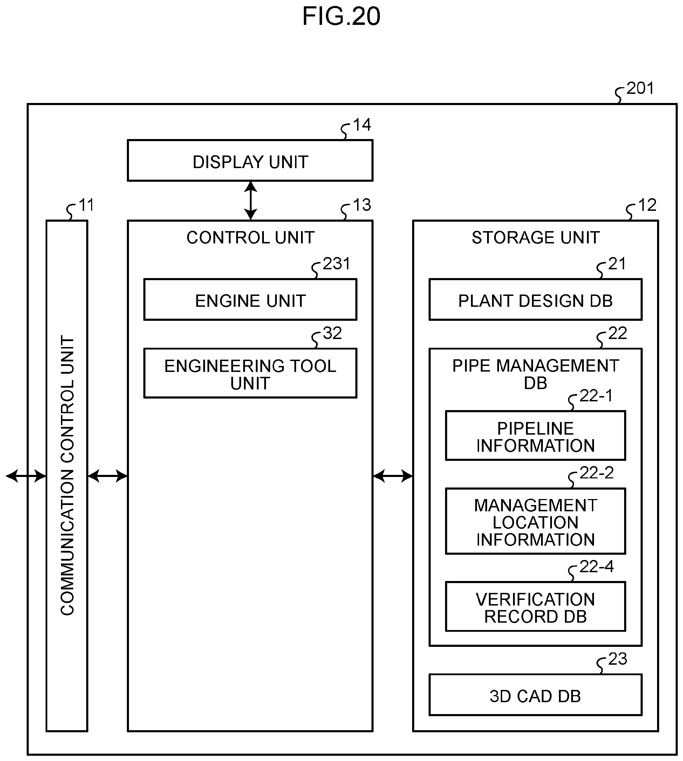

FIG. 20 is a functional block diagram illustrating a function of the apparatus 201 according to the third embodiment. Moreover, components that are the same as those illustrated in FIG. 3 are assigned the same reference numerals and descriptions thereof will be omitted, and, here, a part that is different from that described above with reference to FIG. 3 will be described.

As illustrated in FIG. 20, the pipe management DB 22 included in the storage unit 12 includes a verification record DB 22-4 in which the process information for joining work related to the joining work of the pipe is recorded. The process information includes information that indicates who connects which of the module 2 when, and information that indicates which of the pipes p has been used.

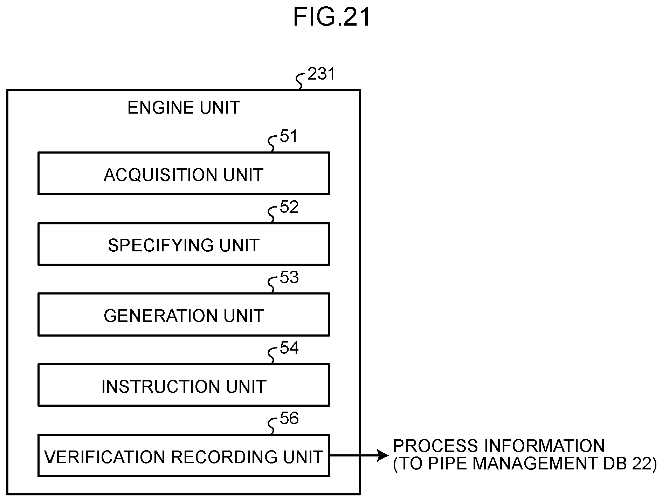

FIG. 21 is a functional block diagram of an engine unit 231 included in the apparatus 201 according to the third embodiment. In FIG. 21, a description will be given by assigning the same reference numerals to components having the same configuration illustrated in FIG. 5. A verification recording unit 56 stores the process information that is related to the joining work of the pipe p in the verification record DB 22-4.

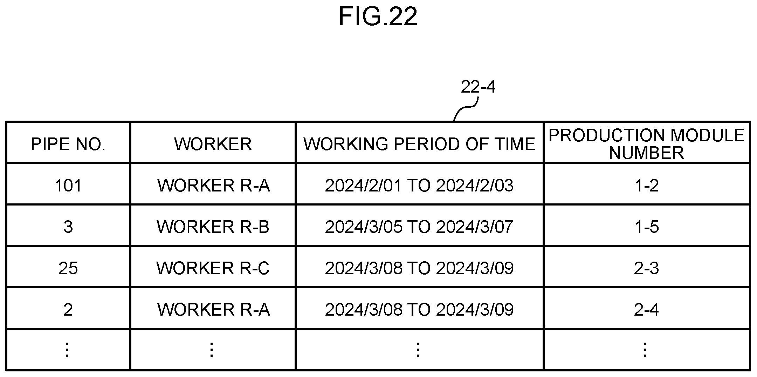

FIG. 22 is a diagram illustrating the verification record DB 22-4 included in the apparatus 201 according to the third embodiment. As illustrated in FIG. 22, the verification record DB 22-4 stores process information for joining work therein, for example, the number assigned to the pipe p, a worker, a working period of time, and a production module number.

FIG. 22 illustrates the information that indicates "a pipe p having a number 101, a worker R-A, a working period of time between 2024/2/01 and 2024/2/03, and a production module number 1-2"; "a pipe p having a number 3, a worker R-B, a working period of time between 2024/3/05 and 2024/3/07, and a production module number 1-5"; "a pipe p having a number 25, a worker R-C, a working period of time between 2024/3/08 and 2024/3/09, and a production module number 2-3"; and "a pipe p having a number 2, a worker R-A, a working period of time between 2024/3/08 and 2024/3/09, and a production module number 2-4".

### (2.3.2. Operation)

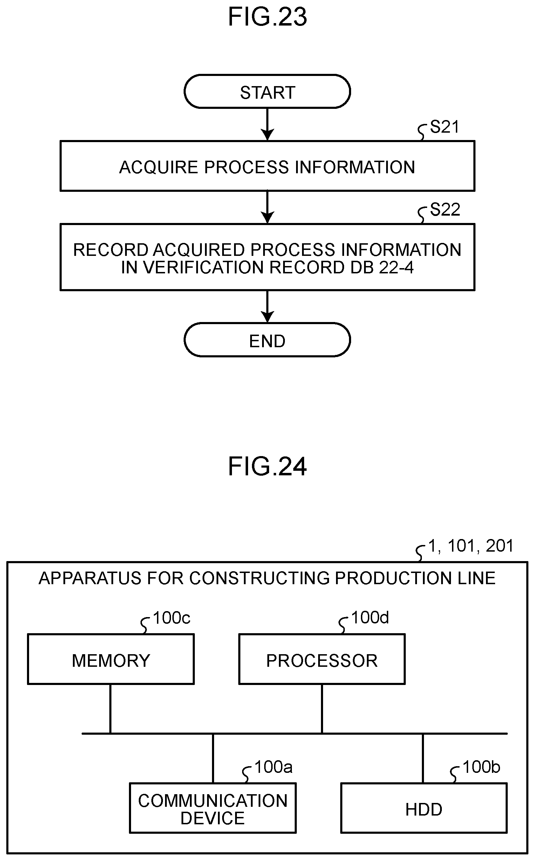

In the following, an operation of the apparatus 201 according to the third embodiment will be described. FIG. 23 is a flowchart illustrating the operation of the apparatus 201 according to the third embodiment.

As illustrated in FIG. 23, the verification recording unit 56 acquires the process information that is related to the joining work of the pipes p (Step S21).

In the following, the verification recording unit 56 records the acquired process information in the verification record DB 22-4 (Step S22), and ends the process.

### (2.3.3. Effects)

Therefore, the verification work process information has been recorded in the verification record DB 22-4, so that the apparatus 201 according to the third embodiment is able to strengthen the quality management process of the verification work, and improve the reliability of the module 2.

Furthermore, the apparatus 201 according to the third embodiment is able to ensure transparency of the process in a case where the verification work process information is detailed verification work process information.

### (3. Hardware)

FIG. 24 is a diagram illustrating an example of a hardware configuration of each of the apparatus 1, the apparatus 101, and the apparatus 201 according to the embodiments.

As illustrated in FIG. 24, each of the apparatus 1, the apparatus 101, and the apparatus 201 includes a communication device 100a, a hard disk drive (HDD) 100b, a memory 100c, and a processor 100d. Furthermore, each of the units illustrated in FIG. 24 is connected by a bus or the like with each other.

The communication device 100a is a network interface card or the like, and performs communication with external equipment or an external device. The HDD 100b stores therein a data and a program that causes the functions illustrated in FIG. 14, FIG. 19, and FIG. 23 to operate.

The processor 100d operates the process that executes each of the functions described above in FIG. 14, FIG. 19, FIG. 23 or the like by reading the program that executes the same processes as those performed by each of the processing units included in the apparatus 1 illustrated in FIG. 14, FIG. 19, and FIG. 23 from the HDD 100b or the like and loading the read program in the memory 100c. For example, the process executes the same functions as those performed by each of the processing units included in the apparatus 1. Specifically, the processor 100d reads, from the HDD 100b or the like, the program having the same functions as those performed by the engine unit 31. Then, the processor 100d executes the same processes as those performed by the engine unit 31.

In this way, each of the apparatus 1, the apparatus 101, and the apparatus 201 operates as an information processing apparatus that executes an information processing method. Furthermore, the apparatus 1 is also able to implement the same functions as those described above in the embodiment by reading the above described program from a recording medium by a medium reading device and executing the read program. In addition, the program described in this embodiment need not always be executed by the apparatus 1. For example, the present invention may also be similarly applied to a case in which another computer or another server executes the program or in a case in which another computer and another server cooperatively execute the program with each other.

The program may be distributed via a network, such as the Internet. Furthermore, the program may be executed by being recorded in a computer readable medium, such as a hard disk, a flexible disk (FD), a CD-ROM, a magneto-optical disk (MO), or a digital versatile disk (DVD), and being read from the recording medium by the computer.

## Claims

1. An information processing apparatus (1) comprising:
an acquisition unit (51) that acquires pipeline information (22-1) related to pipes (p) that connect a plurality of modules (2) included in a modular plant and construction information (40) including information related to the modules; and
a specifying unit (52) that specifies, based on the acquired construction information, pipe information (70) related to a selection and an arrangement of pipelines to be placed between the plurality of modules.

2. The information processing apparatus according to claim 1, wherein
the pipeline information includes the number of pipelines and a size of a system of the pipelines needed for the plurality of modules, and
the specifying unit specifies the pipe information in accordance with the number of pipelines and the size of the system of the pipelines.

3. The information processing apparatus according to claim 1 or 2, wherein the specifying unit specifies, based on the construction information, the pipe information that includes quality of a material of the pipes suitable for the modules, a quantity of the pipes, and a type of the pipes.

4. The information processing apparatus according to claim 3, wherein
the construction information includes physical information (43) that indicates information on a carry in destination of each of the modules and chemical property information (45) that indicates a chemical property of each of the modules, and
the specifying unit specifies the pipe information conforming to the physical information and the chemical property information.

5. The information processing apparatus according to any one of claims 1-4, wherein
the construction information includes management location information (22-2) that indicates a management location of the pipes that are needed to be held and that are used to connect the modules, wherein the information processing apparatus further comprising
a pipe instruction document generation unit (53) that generates, in accordance with the management location information, an instruction document of the pipes that are needed to be held.

6. The information processing apparatus according to claim 5, further comprising a pipe joining instruction unit (54) that outputs a joining instruction of the pipes after the instruction document has been generated.

7. The information processing apparatus according to claim 6, wherein the joining instruction is output based on a preparation status that is related to the pipes that have been read from a radio frequency identification (RFID) or a bar code attached to the pipe.

8. The information processing apparatus according to any one of claims 1-7, further comprising
a stock database (22-3) that manages a stock of the pipes, and
a resource management unit (55) that changes the stock of the pipes indicated by the stock database when there is a change in a joining history or a status of use of the pipes.

9. The information processing apparatus according to any one of claims 1-8, wherein
a verification record database (22-4) in which process information related to joining work of the pipes is recorded, and
a verification recording unit (56) that records the process information related to the joining work of the pipes in the verification record database.

10. The information processing apparatus according to claim 9, wherein the process information includes information that indicates who has joined which of the modules when by using which of the pipes.

11. An information processing method carried out by a computer (1), comprising:
acquiring pipeline information related to pipes that connect a plurality of modules included in a modular plant and construction information including information related to the modules; and
specifying, based on the acquired construction information, pipe information related to a selection and an arrangement of pipelines to be placed between the plurality of modules.

12. A program that causes a computer to execute a process comprising:
acquiring pipeline information related to pipes that connect a plurality of modules included in a modular plant and construction information including information related to the modules; and
specifying, based on the acquired construction information, pipe information related to a selection and an arrangement of pipelines to be placed between the plurality of modules.
